# EUROPEAN PATENT APPLICATION

(11) **EP 4 656 606 A1**
(43) Date of publication of application: **03.12.2025**
(21) Application number: 25179730.4
(22) Date of filing: 29.05.2025
(51) Int. Cl.: C03C 17/04, H05B 3/84

(54) **PRINTED CIRCUIT GLASS**

(30) Priority: 29.05.2024 US 202418677219
(71) Applicant: Tesla, Inc., Austin, TX 78725 (US)
(72) Inventor: MEHTA, Harsh, Austin, 78725 (US); SABIN, Quinn Robert, Austin, 78725 (US); EARLEY, Eric Robert, Austin, 78725 (US); HOOVER, Lana Ann, Austin, 78725 (US); HAGELMUELLER, Robin Maximilian, Austin, 78725 (US)
(74) Representative: Bryn-Jacobsen, Caelia

(57) **Abstract**

The present disclosure relates to automotive windshield technology, specifically to a method and system for providing electrical connectivity to components integrated within an automotive windshield. The system includes a laminated glass structure with low resistance, highly conductive traces printed directly onto one of the glass surfaces. These conductive traces are designed to carry electrical current to various devices that are either embedded in or attached to the windshield, such as sensors and cameras used in advanced driver assistance systems (ADAS). The conductive traces are created in some examples using a conductive paste applied through a screen printing process and cured to form solid conductive lines. This approach eliminates the need for traditional wiring harnesses, simplifies the vehicle assembly process, reduces manufacturing complexity, and allows for more flexible placement of devices on the windshield.

## Description

### TECHNICAL FIELD

The present disclosure relates generally to printed circuit glass and, in some examples, to automotive windshield technology, specifically to printing low resistance traces for powering or connecting devices on laminated glass structures in vehicles. Examples include advancements in integrated electrical systems for powering devices and methods for applying and curing low resistance conductive traces on glass surfaces to facilitate the direct connection of electrical components without the need for traditional wiring harnesses.

### BACKGROUND

Automotive windshields have evolved from mere barriers against environmental elements to complex components that play multiple roles in vehicle functionality and safety. Modern vehicles incorporate various technologies into the windshield, such as heating elements to prevent ice formation and sensors for advanced driver assistance systems (ADAS). These technologies typically require electrical power, which is traditionally supplied through wiring harnesses. Wiring harnesses are networks of electrical cables that provide power and data connectivity to various parts of the vehicle, including the windshield.

Some traditional high resistance elements are used to defrost the windshield in front of cameras for ADAS functionality and at a "wiper park" position to melt or defrost ice around a wiper blade's "park" or non-operational position. prevent the wipers from freezing to the glass. Such traditional designs also typically include a harness that connects these heating elements to the vehicle's power source and other devices on the windshield.

The assembly and integration of these harnesses into the vehicle's structure is a complex process that involves multiple components and steps. As automotive technology advances, the demand for integrating more functionality into the windshield increases, which adds to the complexity of the vehicle's electrical system. This complexity can have implications for manufacturing, maintenance, and vehicle design.

### BRIEF SUMMARY

As mentioned above, automotive windshields serve as the front window of a vehicle, providing visibility for the driver while protecting the vehicle's occupants from the elements. Over time, the functionality of windshields has expanded beyond these basic roles. Today's windshields often incorporate additional features such as defrosting systems and sensors that contribute to vehicle safety and comfort.

One common feature is the windshield heater, which is designed to remove frost, ice, or condensation from the glass. This is typically achieved through the use of heating elements that are integrated into the windshield. These elements are often made from a high resistance wire that has high resistance properties, allowing it to generate heat when an electrical current passes through it. The heat generated by the resistance of the material is sufficient to melt ice or clear condensation, ensuring good visibility through the windshield.

Another feature that is increasingly common in modern vehicles is the integration of sensors and cameras, particularly for vehicles equipped with advanced driver assistance systems (ADAS). These systems rely on clear visibility through the windshield for functions such as adaptive cruise control, lane-keeping assistance, and emergency braking. To maintain this visibility, especially in cold weather, it may be necessary to prevent ice and fog from obscuring the sensors and cameras. This is often achieved by extending the heating elements to the areas of the windshield in front of these devices.

Traditionally, the electrical power needed for these windshield features is supplied through wiring harnesses. A wiring harness is a bundle of wires that provides electrical connections throughout the vehicle. In the context of the windshield, the harness connects the heating elements and sensors to the vehicle's power source and control systems. The harness often requires careful routing and connection during vehicle assembly, which can be a complex and labor-intensive process.

The present disclosure relates to a method and system for providing electrical connectivity to components integrated within an automotive windshield. The system comprises a laminated glass structure with conductive traces printed directly onto one of the glass surfaces. These conductive traces are designed to carry electrical current to various devices that are either embedded in or attached to the windshield.

### BRIEF DESCRIPTION OF THE SEVERAL VIEWS OF THE DRAWINGS

Throughout the drawings, reference numbers may be re-used to indicate correspondence between referenced elements. The drawings are provided to illustrate examples of the subject matter described herein and not to limit the scope thereof.
**FIG. 1** illustrates an aspect of the subject matter in accordance with one example.
**FIG. 2** illustrates an aspect of the subject matter in accordance with one example.
**FIG. 3** illustrates an aspect of the subject matter in accordance with one example.
**FIG. 4** illustrates an aspect of the subject matter in accordance with one example.
**FIG. 5** is a flow diagram illustrating example operations in a method in accordance with one example.
**FIG. 6** is a system block diagram illustrating an architecture of an electric vehicle (EV), according to some examples.

### DETAILED DESCRIPTION

Described examples herein seek to provide a different approach to providing electrical connectivity to the windshield. Instead of using traditional wiring harnesses, some examples involve printing low resistance conductive traces directly onto the windshield. These traces act as pathways for electrical current. In some examples, the conductive traces are created using a conductive paste, which is applied to the windshield using a screen printing process. Once applied, the paste is cured to form solid conductive lines that can carry electrical current.

The conductive paste used for these traces has a much lower resistance than the paste used for heating elements. In some examples, this low resistance can efficiently conduct electricity to power devices without generating unwanted heat. In some examples, the resistance specification for these conductive traces is around 0.1 ohms per meter, which is significantly lower than the resistance of traditional heating elements, which can range from 5 to 10 ohms per meter.

Some described examples also include disclosures of how devices are connected to these conductive traces. One example method involves the use of spring contacts or other types of connectors that can make a secure electrical connection with the traces. These connectors can be attached to the windshield and provide a point where devices, such as sensors or controllers, can be connected to the electrical system without the need for a traditional wiring harness.

By printing low resistance conductive traces directly onto the windshield, the described examples aim to simplify the vehicle assembly process. In some examples, this approach may reduce the number of components required for electrical connectivity and potentially streamline the manufacturing process. Additionally, it could offer more flexibility in the placement and integration of devices on the windshield.

Some described examples also contemplate powering a wider range of devices through the conductive traces. With the ability to carry electrical power directly on the windshield, it is possible to integrate additional features and components that were not feasible with traditional wiring harnesses. These components may include sensors, lighting, cameras or other electronic components that enhance the functionality of the windshield and the vehicle. By using printed low resistance conductive traces, some examples seek to address the complexities associated with traditional wiring harnesses and open up new possibilities for integrating technology into the windshield.

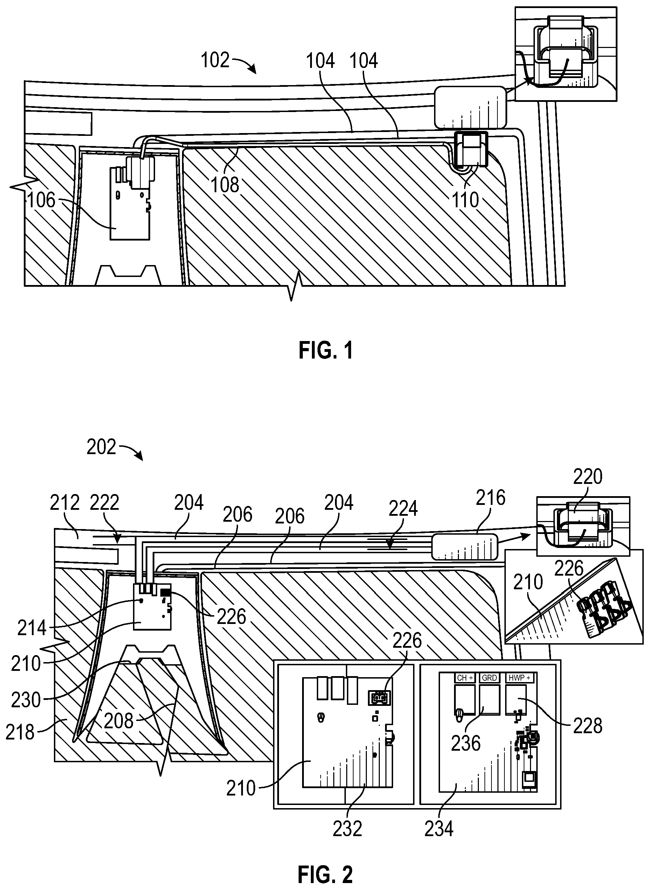

**FIG. 1** shows a pictorial view of a section of a traditional windshield 102. One common feature is a windshield heater that is designed to remove frost, ice, or condensation from the glass. This is typically achieved through the use of one or more high resistance heating elements 104 elements that are integrated into the windshield. These elements are often made from a high resistance wire that has high resistance properties, allowing it to generate heat when an electrical current passes through it. The heat generated by the resistance of the material is sufficient to melt ice or clear condensation, ensuring good visibility through the windshield.

Another feature that is increasingly common in modern vehicles is the integration of sensors and cameras, particularly for vehicles equipped with advanced driver assistance systems (ADAS), typically positioned in an upper, central area of the traditional windshield 102, for example as shown at ADAS components 106. These systems rely on clear visibility through the windshield for functions such as adaptive cruise control, lane-keeping assistance, and emergency braking. To maintain this visibility, especially in cold weather, it may be necessary to prevent ice and fog from obscuring the sensors and cameras. This is often achieved by extending the high resistance heating elements 104 to the areas of the windshield in front of these devices. Sometimes traditional high resistance heating elements 104 are also used to defrost the traditional windshield 102 at a "wiper park" position to prevent the windshield wipers from freezing to the glass.

Traditionally, the electrical power needed for these ADAS components 106 is supplied through wiring harnesses, such as a wiring harness 108. A wiring harness is a bundle of wires that provides electrical connections throughout the vehicle. In the context of the windshield, the harness connects the heating elements and sensors to the vehicle's power source, for example the power source 110, and other control systems. The harness must be carefully routed and connected during vehicle assembly, which can be a complex and labor-intensive process. This traditional approach can suffer from certain drawbacks discussed further above.

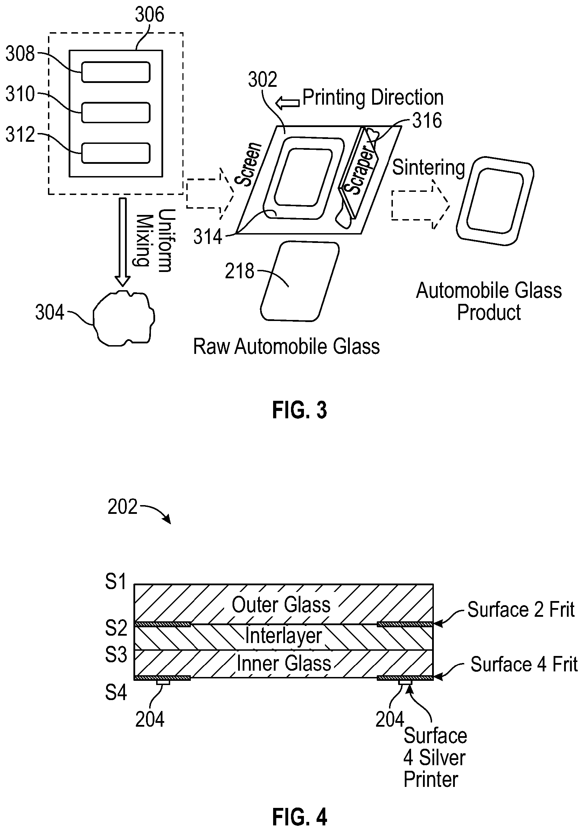

**FIG. 2** shows a pictorial view of a windshield 202 of a vehicle. Some examples herein provide methods of providing electrical connectivity to the windshield 202. In one aspect, the windshield 202 includes a glass substrate 218, and one or more low resistance traces 204 screen-printed onto the glass substrate 218 using a conductive paste. An example conductive paste and a method of screen-printing it are described further below. A cross-sectional view of an example glass substrate 218 is shown in **FIG. 4** described further below. In some examples, a low resistance trace 204 is screen printed on top of or under a layer of black ceramic frit 212.

In some examples, the linear resistance of the low resistance trace 204 is much lower than a conventional heating wire or trace. In some examples, the low resistance trace 204 has a linear resistance in a range 0.05-5 ohm/meter. In some examples, the low resistance trace 204 has a linear resistance in a range 0.1-3 ohm/meter. In some examples, the low resistance trace 204 has a linear resistance in a range 0.1-1 ohm/meter. In some examples, the low resistance trace 204 has a linear resistance of 0.1 ohm/meter.

In some examples, these low values of linear resistance endow the low resistance trace 204 with a much higher conductivity than a conventional heating wire or trace. In some examples, this low resistance (or high conductivity) can efficiently conduct electricity to power devices without generating unwanted heat. In some examples, the resistance specification for these highly conductive traces is significantly lower than the resistance of traditional heating elements that can range from 5 to 10 ohms/meter.

In some examples, a width 222 of a low resistance trace 204 is provided in a range of 3-10 millimeters (mm) on a windshield 202. In some examples, the width of a low resistance trace 204 is held constant along its length at a width of approximately 4 mm. Other widths of a low resistance trace 204 are possible, for example to adjust a linear resistance value or conductivity of a low resistance trace 204.

In some examples, a low resistance trace 204 is insulated from another low resistance trace 204 on the windshield 202, for example as shown between the pair of low resistance traces 204 in **FIG. 2****,** by a trace separation distance 224. In some examples, a trace separation distance 224 is provided in a range of 2-10 mm, and in some examples provided in a trace separation distance 224 of at least 5 mm. Other trace separation distances are possible, for example to adjust a degree of insulation between low resistance traces 204 running in parallel directions across a windshield 202.

In some examples, a connector 216 is electrically connected to one or more low resistance traces 204 on the windshield 202. In some examples, the connector 216 is integrated onto the glass substrate 218 for electrically connecting the low resistance trace 204 to an automotive electrical panel 210, a component 214, or a power source 220. In some examples, these electrical connections can be conveniently made without the need for a conventional wiring harness, such as the wiring harness 108 of **FIG. 1****.** Electrical access to a component 214 may be facilitated by the provision of an automotive electrical panel 210 to one or more low resistance traces 204. In some examples, the automotive electrical panel 210 is provided in or adjacent a camera zone 230 of the windshield 202. The automotive electrical panel 210 has an outer surface 232 (i.e., facing an exterior of the vehicle) and an inner surface 234 (i.e., facing an interior of the vehicle). In some examples, the connector 216 can be electrically connected to a power source 220 to supply power to the automotive electrical panel 210 and/or the component 214.

In some examples, the windshield 202 further comprises one or more first high resistance traces 206 and one or more second high resistance traces 208. In some examples, a first high resistance trace 206 and/or a second high resistance trace 208 is also screen printed onto the windshield 202 but in these instances an electrically high resistance paste is used in the screen printing process. In some examples, one or more first high resistance traces 206 may power or serve as an ice-releasing heater for a windscreen wiper at a "park" position. The park position may lie along a lower edge of the glass substrate 218 of the windshield 202. In some examples, one or more second high resistance traces 208 may power or serve as a demisting heater for a camera in the camera zone 230 of the windshield 202. Power connections to a first high resistance trace 206 and/or a second high resistance trace 208 can be made in some examples via one or more heater contacts 228 provided on the inner surface 234 of the automotive electrical panel 210. These are marked CH (camera heater) and HWP (heater for wiper park) merely by way of example. A ground contact 236 (marked GRD) is also provided in some examples. Electrical connections to these heater contacts 228 is facilitated in some examples by the provision of one or more contactors 226. The contactors 226 may be spring-biased or otherwise configured to facilitate secure and ready connections to other components, or external devices when needed, for example.

With reference to **FIG. 3****,** in some examples, a conductive paste 304 from which the low resistance trace 204 is formed by screen printing is constituted by, or includes, a silver paste 306. In some examples, the silver paste 306 includes an inorganic ceramic frit 308, a silver-based compound 310, and a liquid medium 312. Further or other ingredients of the conductive paste 304 are possible, for example as described below.

A mesh screen 302 is prepared with the desired pattern 314 for one or more low resistance traces 204 to be formed onto the glass substrate 218 of a windshield 202. The mesh screen 302 allows the conductive paste 304 to pass through in specific areas corresponding to the pattern 314. A simple rectangular pattern 314 is shown in the view merely by way of example. Other more complex, fine-lined, and/or sophisticated patterns 314 for the one or more low resistance traces 204 on the glass substrate 218 are possible.

In an example application of the conductive paste 304, the conductive paste 304 is deposited onto the glass substrate 218. A scraper 316 is then used to press the conductive paste 304 through the mesh screen 302 and onto the glass substrate 218 (i.e., an inner surface of the windshield 202 in some examples). The pressure and angle of the scraper 316 are controlled to ensure a consistent application.

In an example transfer of the pattern 314, as the scraper 316 moves across the glass substrate 218, the conductive paste 304 is transferred onto the glass substrate 218 in the pattern 314 defined by the mesh screen 302. In some examples, the thickness of the paste layer can be adjusted by the mesh count of the mesh screen 302 and the viscosity of the conductive paste 304.

In an example removal of the mesh screen 302, after the conductive paste 304 is applied, the mesh screen 302 is lifted away, leaving the patterned conductive paste 304 on the glass substrate 218, i.e., the windshield surface.

Once the conductive paste 304 is applied, it must be cured in some examples to form a solid conductive trace (i.e., a low resistance trace 204). Curing methods may vary depending on the type of conductive paste 304 used, but some examples include thermal curing in which the glass substrate 218 or windshield 202 to which the conductive paste 304 has been applied is placed in an oven or passed through a heating tunnel where controlled heat is applied to cure the conductive paste 304. For conductive pastes 304 that are sensitive to ultraviolet (UV) light, a UV curing process may be used. The applied conductive paste 304 is exposed to UV radiation, which initiates a chemical reaction that solidifies the paste. Some conductive pastes 304 may cure at room temperature over time. This method is less common for automotive applications due to the longer curing times required.

In some applications, the conductive paste 304 is a significant component of a system and/or method of providing electrical connectivity to a windshield of a vehicle, as its properties determine the electrical performance of the traces. Options for conductive pastes 304 may include silver-based pastes. Silver offers high conductivity and is a convenient choice for conductive applications. Silver pastes can be formulated with a mixture of silver particles and a binder to create a printable substance.

Other or further examples may include copper-based pastes. Copper is another highly conductive material that can be used in paste form. Copper pastes may require oxidation prevention measures to maintain conductivity. Other or further examples may include carbon-based pastes. Carbon or graphite pastes offer lower conductivity than metals but can be cost-effective alternatives for certain applications. Other or further examples may include conductive polymers. Intrinsically conductive polymers can be used to form low resistance traces 204, though they typically offer lower conductivity compared to metals.

Each conductive paste 304 option may have its own set of properties, including resistance, adhesion, flexibility, and environmental stability. The choice of conductive paste 304 may depend on the specific requirements of the application, such as the amount of current the traces need to carry and the environmental conditions they will be exposed to. In some examples, a manufacturing process for applying conductive traces to windshields includes an orchestrated sequence of screen printing and curing, utilizing conductive pastes selected for their electrical properties and compatibility with automotive standards.

In some examples, a method for providing electrical connectivity to a windshield of a vehicle, comprises: applying a conductive paste onto a surface of the windshield in a predetermined pattern via a screen printing process; curing the conductive paste to form low resistance conductive traces; and connecting electrical components to the low resistance conductive traces.

In some examples, the conductive paste comprises a silver-based material. In some examples, the conductive paste comprises a copper-based material. In some examples, the conductive paste comprises a carbon-based material. In some examples, the conductive paste comprises an intrinsically conductive polymer.

In some examples, curing the conductive paste includes a thermal curing process. In some examples, curing the conductive paste includes a UV curing process.

In some examples, the low resistance conductive traces have an electrical resistance of approximately 0.1 ohms per meter.

In some examples, a windshield for a vehicle, comprises: a laminated glass structure; low resistance conductive traces formed on a surface of the laminated glass structure from a cured conductive paste; and connectors interfacing with the low resistance conductive traces to provide electrical power to devices attached to the windshield. In some examples, the low resistance conductive traces are formed using a screen printing process. In some examples, the conductive paste is selected from the group comprising silver-based materials, copper-based materials, carbon-based materials, and/or conductive polymers. In some examples, the connectors comprise spring contacts.

In some examples, a system for powering devices on a windshield of a vehicle, comprises: one or more low resistance conductive traces screen printed onto the windshield; a connector assembly attached to the windshield and electrically connected to the one or more conductive traces; and one or more devices powered by the conductive traces. In some examples, the one or more devices include sensors for an advanced driver assistance system. In some examples, the one or more devices include a heating element for defrosting the windshield. In some examples, the low resistance conductive traces are configured to distribute power to multiple devices simultaneously.

In some examples, the low resistance conductive traces are printed on an inner surface of the windshield facing the vehicle cabin. In some examples, the connector assembly is attached to the windshield using an adhesive. In some examples, the low resistance conductive traces are printed in a pattern that corresponds to the layout of the devices on the windshield. In some examples, the low resistance conductive traces are printed with varying widths to accommodate different current carrying requirements of the devices.

In other aspects, a conductive paste 304 used for the creation of low resistance conductive traces on a windshield exhibits a linear resistance not exceeding 0.1 ohm/meter. This engineering requirement may be satisfied in some examples through the selection of conductive metals or by optimizing the geometry of the printed trace, such as increasing the trace width to diminish resistance. In the event that a conductive paste 304 does not fulfill the viability criteria, alternative materials may be considered. Some examples demonstrate an ability to fuse with ceramic enamel in a manner comparable to silver, thereby seeking to ensure compatibility with the screen printing process on glass substrates.

In some examples, a screen printing process begins with the deposition of inorganic ceramic paste onto a glass surface. The ceramic paste may be included in, or provide, a conductive paste 304 as described above. In some examples, the ceramic paste is a blend of glass "frit" (small granular glass fragments), pigments for coloration, and a medium that acts as a solvent. The mixture of glass frit, pigment, and medium results in a ceramic paste that, upon application and subsequent heating, softens and fuses to form a durable glass layer that is both chemically and mechanically bonded to the substrate. This paste may be prepared in a premixed form or as a powder that is later combined with a medium.

In some examples, the screen printing process is conducted on the "air side" of the glass to ensure a defect-free application. The printing environment is free of dust to prevent surface defects. Following the printing, a drying or pre-firing stage may be conducted to eliminate moisture.

Post-printing, the applied ceramic paste (e.g., conductive paste 304) is subjected to firing, typically in a bending furnace at temperatures above 600°C. This step ensures the complete combustion of the medium, leaving only the frit and pigment. The resulting frit becomes an integral part of the glass surface, exhibiting exceptional durability and suitability for various applications, such as resistant to fading, UV exposure, temperature variations, and chemicals.

In some examples, a minimum width for screen-printed low resistance traces 204 is 0.4 mm. The layout of these low resistance traces 204 may be determined based on the location of a device to be powered and the connection points on the vehicle body. To ensure electrical isolation, some low resistance traces 204 are printed with a minimum separation of 5 mm and may be positioned atop or beneath a layer of black ceramic frit.

While in some examples, there may be no predefined maximum for current and voltage that the printed low resistance traces 204 can handle, the design is tailored to the supply voltage and the power and heating requirements of a given component. For applications beyond heating, such as the examples disclosed herein, testing is conducted in some examples to ascertain the maximum current and voltage capabilities, to confirm for example that a silver low resistance trace 204 can accommodate up to 48V automotive devices. In some examples, the electrical performance of the low resistance traces 204 is not significantly affected by environmental factors such as temperature and humidity, similar to wire conductors, as they are typically shielded from the vehicle's "wet-side".

To ensure the durability of the highly conductive low resistance traces 204, a series of tests were conducted on some examples, including a functional integrity test involving cycles of exposure to extreme temperatures and humidity levels. These tests confirm that the glazing assemblies maintain full integrity between -40°C and +108°C across a humidity range of 0% to 100%, with no delamination permitted for the silver print.

With reference to **FIG. 4****,** in some examples, the windshield 202, being a safety glazing component, complies with regulations such as FMVSS 205, which mandate that it must not permit penetration and maintain a certain level of strength. Consequently, the windshield 202 is constructed as a laminated glass stack as shown for example, comprising at least two pieces of glass bonded with an interlayer that upholds this requisite strength level. Example low resistance traces 204 are shown formed by screen printing on an air-side surface S4 on the windshield 202.

Some examples herein facilitate integration with vehicle electrical systems. To this end, a printed conductive low resistance trace 204 may include the use of a contactor (such as a contactor 226, FIG. 2). Further considerations for the vehicle's electronic control unit (ECU) may include maintaining connections with the main controller via vehicle harnesses. These harnesses connect to the windshield through a primary connector, which, in turn, requires a contactor on the opposing side to conduct current to the printed trace. Upon windshield assembly to the vehicle, the contactors establish contact, enabling electrical connectivity. Further examples may thus include new contactor designs or replacements for coaxial cables, and optimization.

In some examples, the technology disclosed herein extends beyond windshields to other applications, such as printing conductive traces on glass for additional positions. For instance, a Center High Mount Stop Light (CHMSL) can be added to the rear windshield glass (also known as backlite) by bonding it with tape, provided it is equipped with a contactor. Additionally, the conductive paste 304 can be printed on plastic for radar heaters on fascia using digital printing or for powering devices like ultrasonic sensors on fascia without the need for wire harnesses.

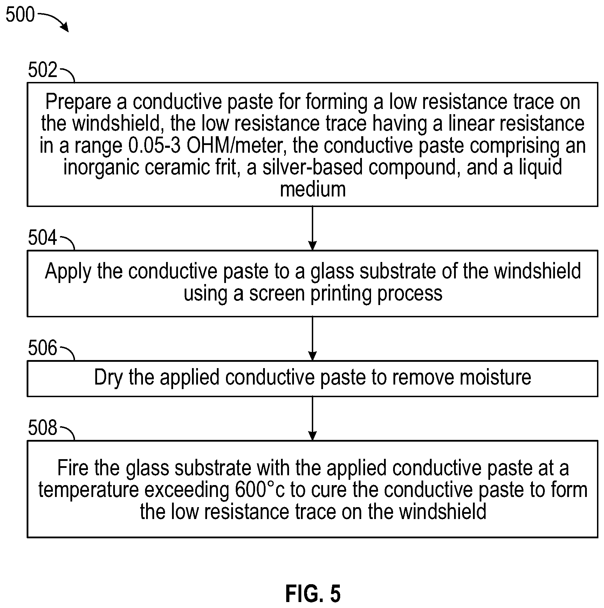

Some examples herein include methods. With reference to **FIG. 5****,** in some examples, a method 500 of providing electrical connectivity to a windshield of a vehicle is provided. Although the described flow diagrams herein can show operations as a sequential process, many of the operations can be performed in parallel or concurrently. In addition, the order of the operations may be re-arranged. A process is terminated when its operations are completed. A process may correspond to a method, a procedure, an algorithm, etc. The operations of methods may be performed in whole or in part, may be performed in conjunction with some or all of the operations in other methods, and may be performed by any number of different systems, such as the systems described herein, or any portion thereof, such as a processor included in any of the systems.

In operation 502, the method 500 includes preparing a conductive paste for forming a low resistance trace on the windshield, the low resistance trace having a linear resistance in a range 0.05-3 ohm/meter, the conductive paste comprising an inorganic ceramic frit, a silver-based compound, and a liquid medium. In operation 504, the method 500 includes applying the conductive paste to a glass substrate of the windshield using a screen printing process. In operation 506, the method 500 includes drying the applied conductive paste to remove moisture. In operation 508, the method 500 includes firing the glass substrate with the applied conductive paste at a temperature exceeding 500°C to cure the conductive paste to form the low resistance trace on the windshield.

The method may also include where the low resistance trace has a linear resistance in a range 0.1-2 ohm/meter. The method may also include where the low resistance trace has a linear resistance in a range 0.1-1 ohm/meter. The method may also include where the low resistance trace has a linear resistance of 0.1 ohm/meter. The method may also include where a width of the low resistance trace is in a range of 3-10 millimeters (mm). The method may also include where a width of the low resistance trace is 4 mm. The method may also include where the conductive paste further includes a pigment. The method may also include where the conductive paste is prepared by mixing a pre-mixed frit and the silver-based compound with the liquid medium. The method may also include where the conductive paste is prepared by mixing a powder form of frit and silver-based enamel with the liquid medium. The method may also include where the conductive paste is applied to an air side of the glass substrate. The method may also include where the silver-based compound in included in a silver-based enamel. The method may also include further includes testing the formed low resistance trace for a linear resistance value. The method may also further include applying a connector on the glass substrate to connect the low resistance trace to an automotive electrical panel, a component, or a power source. The method may also include where the low resistance trace is insulated from another low resistance trace by a trace separation distance of at least 5 mm. The method may also include where the low resistance trace is printed on top of or under a layer of black ceramic frit. Other technical features may be readily apparent to one skilled in the art from the following figures, descriptions, and claims.

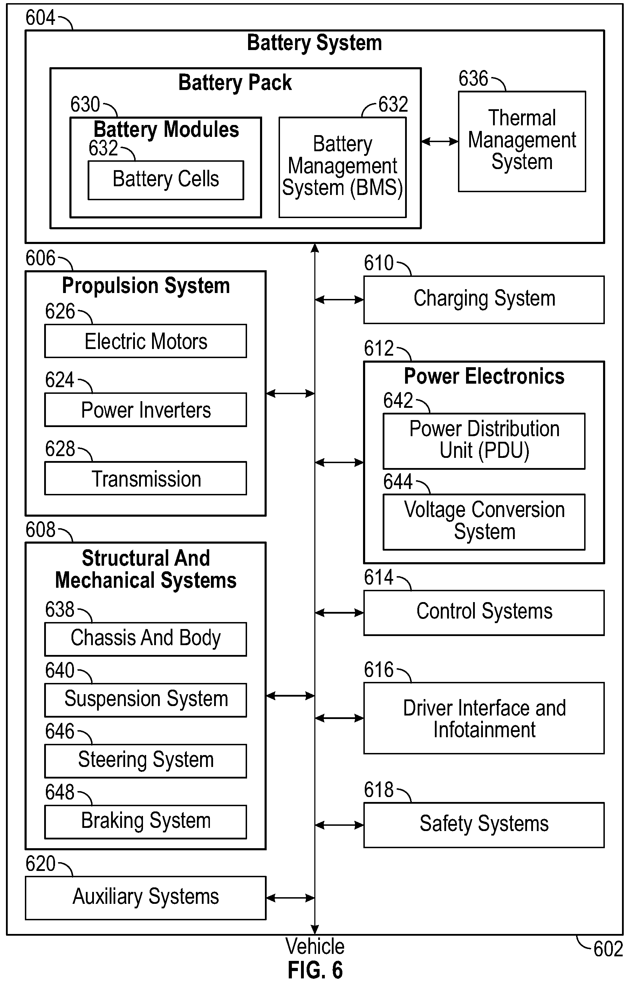

**FIG. 6** is a block diagram of an example system illustrating an architecture of an electric vehicle (EV) 602, according to some examples. This diagram shows systems and sub-systems that collectively enable the functionality and operational efficiency of the electric vehicle 10.

The vehicle 602 includes a number of higher-level systems which are interconnected, including a battery system 604, a propulsion system 606, structural and mechanical systems 608, a charging system 610, power electronics 612, control systems 614, driver interface and infotainment 616, safety systems 618, and auxiliary systems 620.

The propulsion system 606 includes one or more electric motors 13, which may include traction motors for propulsion and motors for regenerative braking systems, convert electrical energy into mechanical energy. Power inverters 624, facilitate the conversion of DC power from the battery to AC power required by the electric motors 626. The propulsion system also includes a transmission 628, which may consist of a single-speed transmission or gearbox, channeling mechanical power to the vehicle's wheels.

The battery system 604 is composed of several battery modules 630, each housing multiple battery cells 632. These battery cells 632 may be based on various chemistries, including lithium-ion, lithium-polymer, or solid-state materials, each offering distinct features and/or abilities in terms of energy density, recharge cycles, and safety profiles.

A battery management system (BMS) 634 continuously monitors various parameters, such as voltage, current, and temperature of each of the battery cells 632 and battery modules 630, to prevent conditions that could lead to overcharging, deep discharging, or thermal runaway. The battery management system (BMS) 634 also manages the state of charge (SoC) and state of health (SoH) of the battery, ensuring that the energy is distributed during discharge and that the charging process is optimized for longevity and safety. Each battery management system (BMS) 634 employs algorithms to balance the charge across the cells and modules, correcting imbalances that can reduce the battery's overall capacity and lifespan.

Integrated with the battery system 604 is a thermal management system 636, which operatively maintains the battery cells 632 within specified temperature ranges. The thermal management system 636 employs temperature sensors to monitor the heat generated by the battery cells 632 during operation. Based on the data collected, it activates cooling and heating mechanisms to regulate the battery's temperature. Cooling methods can include air cooling, where ambient air is circulated around the battery modules, or liquid cooling, where a coolant is circulated through channels in or around the battery modules to absorb and dissipate heat. In colder environments, the thermal management system 636 may employ heating elements or use waste heat from the vehicle's systems to warm the battery cells, ensuring they operate efficiently even in low temperatures.

The charging system 610 operatively replenishes the stored energy within the battery system 604 of the electric vehicle 602. It supports various charging methodologies to ensure flexibility and convenience in energy restoration. The charging system 610 may encompass systems for both standard (Level 1 and Level 2) and fast charging (DC fast charging), facilitating a range of charging speeds to suit different user needs and infrastructure capabilities.

For standard charging, the charging system 610 includes an onboard charger for AC/DC conversion. This onboard charger converts the alternating current (AC) from the electrical grid or home outlets into direct current (DC) that can be stored in the vehicle's battery system 604. The onboard charger may, for example support Level 1 and Level 2 charging, with Level 1 charging using standard household outlets (608-120V) and Level 2 charging requiring a higher voltage source (208-240V), such as those found in dedicated charging stations or installed in residential garages.

For fast charging, the charging system 610 may incorporate a DC fast charging system, designed for rapid energy transfer directly to the vehicle's battery system 604, bypassing the onboard charger. DC fast charging stations supply high-voltage (e.g., 400V to 800V) direct current directly to the battery system 604.

Additionally, the electric vehicle 602 may be equipped with an auxiliary battery, such as a 12V lead-acid or lithium-ion battery may be tasked with powering the vehicle's low-voltage systems, including lighting, infotainment, electronic control units, and other ancillary components, ensuring their operation even when the main battery system is off or during the initial stages of charging when the main system's voltage might be too low for these tasks. This separation of power sources enhances the vehicle's electrical system reliability and ensures the availability of potentially essential functions.

Structural and mechanical systems 608, including a chassis and body 638 and suspension system 640, provide the physical framework and support for the vehicle 602. The chassis and body 638 constitute the vehicle's primary structure, while the suspension system 640, which may include springs, shock absorbers (or dampers), and control arms, to provide a smooth and stable ride by mitigating road shocks and vibrations.

Power electronics 612, including a power distribution unit (PDU) 642 and a voltage conversion system 644, are responsible for the management and conversion of electrical power within the vehicle. The power distribution unit (PDU) 642, equipped with fuses and relays, distributes power to various vehicle systems, while voltage conversion devices of the voltage conversion system 644, such as DC/DC and AC/DC converters, adjust the voltage levels to meet the specific requirements of different components.

Control systems 614 facilitate the driver's command over the vehicle, with a steering system 646 and a braking system 648 as examples. The steering system 646, including a power steering motor, allows for precise directional control, whereas the braking system 648, which may feature disc brakes and an anti-lock braking system (ABS), enables deceleration and stopping.

The driver interface and infotainment 616 supports the driving experience by providing vehicle information and entertainment options through digital displays and multimedia systems. Connectivity features, such as Bluetooth and USB, further augment functionality.

Safety systems 618, designed to protect the vehicle's occupants, may include airbag systems and advanced driver-assistance systems (ADAS), for example. ADAS may use an array of sensors, cameras, radar, LiDAR, and/or ultrasonic devices to monitor the vehicle's surroundings, detect potential hazards, and execute or suggest corrective actions to prevent accidents and mitigate their impact.

ADAS can be categorized into different levels of self-driving capabilities, ranging from Level 0, where the human driver performs all driving tasks, to Level 5, which represents full automation with no human intervention required under any circumstances. Levels 1 and 2 focus on driver assistance and partial automation, respectively, where systems such as adaptive cruise control, lane-keeping assistance, and automatic emergency braking support the driver but do not replace them. Level 3, conditional automation, allows the vehicle to handle all aspects of driving in certain conditions, but requires the driver to be ready to take control when needed. Level 4, high automation, enables the vehicle to operate independently in most scenarios, though human override is still possible.

Examples of ADAS that contribute to these levels of automation include, but are not limited to, adaptive cruise control, which adjusts the vehicle's speed to maintain a safe distance from vehicles ahead; lane departure warning systems, which alert the driver when the vehicle begins to drift out of its lane; and automatic parking systems, which assist or take over control of the vehicle during parking maneuvers. More advanced systems, contributing to higher levels of automation, involve complex algorithms and machine learning capabilities to interpret sensor data, predict actions of other road users, and make real-time driving decisions.

Auxiliary systems 620 support the vehicle's functions and occupant comfort, with climate control and lighting systems as examples. The auxiliary systems 620 may also include windshield wipers etc.

As noted above, the systems of the 602 are communicatively connected. Communications between the interconnected systems within vehicle 602 are facilitated through a vehicle network architecture, employing both hardware and software components to ensure seamless data exchange and coordination. This network architecture may include one or more vehicle communication buses, such as for example Controller Area Network (CAN), Local Interconnect Network (LIN), FlexRay, and Ethernet, which serve as the backbone for intra-vehicle communications.

The Controller Area Network (CAN) bus is a vehicle bus standard designed to allow microcontrollers and devices to communicate with each other within the vehicle 602 without a host computer. Such a network may support control communications between systems such as the battery system 604, propulsion system 606, and control systems 614, due to its high reliability and resistance to interference. A CAN bus may support messages that ensure real-time control and monitoring of these systems.

For other communications, such as those involving the driver interface and infotainment 616 or auxiliary systems 620, a Local Interconnect Network (LIN) bus may be employed. LIN may provide a cost-effective, low-speed serial communication system for connecting intelligent sensors and actuaries. It may serve as a sub-network to the CAN bus, handling signals such as switch inputs and actuator outputs.

FlexRay technology offers a higher data rate compared to CAN and LIN, providing the necessary bandwidth for advanced control systems, including those required for autonomous driving functionalities within safety systems 618. Its deterministic nature and fault tolerance make it suitable for applications that require precise timing and synchronization, such as coordinating the actions of multiple control units in real-time.

Ethernet, with its high data transfer rate, may for example be adopted for diagnostics and infotainment applications within the vehicle 602. It supports the rapid transfer of large volumes of data, making it well suited for advanced driver assistance systems (ADAS), software updates, and multimedia streaming in the driver interface and infotainment 616 system.

Software protocols and application programming interfaces (APIs) built on top of these physical layers enable high-level communication and data exchange between systems. These protocols may define the rules for data format, timing, and error handling, ensuring that messages are correctly interpreted and acted upon by the receiving systems.

### EXAMPLES

Thus, some examples may include one or more of the following examples.

Example 1. A method of providing electrical connectivity to a windshield of a vehicle, the method comprising: preparing a conductive paste for forming a low resistance trace on the windshield, the low resistance trace having a linear resistance in a range 0.05-3 ohm/meter, the conductive paste comprising an inorganic ceramic frit, a silver-based compound, and a liquid medium; applying the conductive paste to a glass substrate of the windshield using a screen printing process; drying the applied conductive paste to remove moisture; and firing the glass substrate with the applied conductive paste at a temperature exceeding 600°C to cure the conductive paste to form the low resistance trace on the windshield.

Example 2. The method of example 1, wherein the low resistance trace has a linear resistance in a range 0.1-2 ohm/meter.

Example 3. The method of example 2, wherein the low resistance trace has a linear resistance in a range 0.1-1 ohm/meter.

Example 4. The method of example 3, wherein the low resistance trace has a linear resistance of 0.1 ohm/meter.

Example 5. The method of any one of examples 1-4, wherein a width of the low resistance trace is in a range of 3-10 millimeters (mm).

Example 6. The method of example 5, wherein a width of the low resistance trace is 4 mm.

Example 7. The method of any one of examples 1-6, wherein the conductive paste further comprises a pigment.

Example 8. The method of any one of examples 1-7, wherein the conductive paste is prepared by mixing a pre-mixed frit and the silver-based compound with the liquid medium.

Example 9. The method of any one of examples 1-8, wherein the conductive paste is prepared by mixing a powder form of frit and silver-based enamel with the liquid medium.

Example 10. The method of any one of examples 1-9, wherein the conductive paste is applied to an air side of the glass substrate.

Example 11. The method of any one of examples 1-10, wherein the silver-based compound in included in a silver-based enamel.

Example 12. The method of any one of examples 1-11, further comprising testing the formed low resistance trace for a linear resistance value.

Example 13. The method of any one of examples 1-12, further comprising applying a connector on the glass substrate to connect the low resistance trace to an automotive electrical panel, a component, or a power source.

Example 14. The method of any one of examples 1-13, wherein the low resistance trace is insulated from another low resistance trace by a trace separation distance of at least 5 mm.

Example 15. The method of any one of examples 1-14, wherein the low resistance trace is printed on top of or under a layer of black ceramic frit.

Example 16. A windshield comprising: a glass substrate; and a low resistance trace screen-printed onto the glass substrate using a conductive paste, the low resistance trace having a linear resistance in a range 0.05-3 ohm/meter.

Example 17. The windshield of example 16, wherein the low resistance trace has a linear resistance in a range 0.1-2 ohm/meter.

Example 18. The windshield of example 17, wherein the low resistance trace has a linear resistance in a range 0.1-1 ohm/meter.

Example 19. The windshield of example 18, wherein the low resistance trace has a linear resistance of 0.1 ohm/meter.

Example 20. The windshield of example 16, wherein a width of the low resistance trace is in a range 3-10 millimeters (mm).

Example 21. The windshield of example 20, wherein a width of the low resistance trace is 4 mm.

Example 22. The windshield of any one of examples 16-21, further comprising a connector integrated onto the glass substrate for connecting the low resistance trace to an automotive electrical panel, a component, or a power source.

Example 23. The windshield of any one of examples 16-22, wherein the conductive paste comprises a silver-based compound.

Example 24. The windshield of any one of examples 16-23, wherein the low resistance trace is insulated from another low resistance trace by a trace separation distance of at least 5 mm.

Example 25. The windshield of any one of examples 16-24, wherein the low resistance trace is printed on top of or under a layer of black ceramic frit.

While disclosed examples herein may relate to automotive windscreen technology, other examples and applications are possible. Other examples may generally include methods and system for applying and curing low resistance conductive traces on other glass surfaces to facilitate the connection of electrical components, and other products may by such methods and systems.

It should be noted that the description and the figures above merely illustrate the principles of the present subject matter along with examples described herein and should not be construed as a limitation to the present subject matter. It is thus understood that various arrangements may be devised that although not explicitly described or shown herein, embody the principles of the present subject matter. Moreover, all statements herein reciting principles, aspects, and implementations of the present subject matter, as well as specific examples thereof, are intended to encompass equivalents thereof.

It is to be understood that not necessarily all objects or advantages may be achieved in accordance with any particular example described herein. Thus, for example, those skilled in the art will recognize that some examples may be operated in a manner that achieves or optimizes one advantage or group of advantages as taught herein without necessarily achieving other objects or advantages as may be taught or suggested herein.

All of the processes described herein may be embodied in, and fully automated via, software code modules executed by a computing system that includes computers or processors. The code modules may be stored in any type of non-transitory computer-readable medium or other computer storage device. Some or all the methods may be embodied in specialized computer hardware.

Many other variations than those described herein will be apparent from this disclosure. For example, depending on the example, some acts, events, or functions of any of the algorithms described herein can be performed in a different sequence, can be added, merged, or left out altogether (for example, not all described acts or events are necessary for the practice of the algorithms). Moreover, in some examples, acts or events can be performed concurrently, for example, through multi-threaded processing, interrupt processing, or multiple processors or processor cores, or on other parallel architectures, rather than sequentially. In addition, different tasks or processes can be performed by different machines and/or computing systems that can function together.

The various illustrative logical blocks and modules described in connection with the examples disclosed herein can be implemented or performed by a machine, such as a processing unit or processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A processor can be a microprocessor, but in the alternative, the processor can be a controller, microcontroller, or state machine, combination of the same, or the like. A processor can include electrical circuitry to process computer-executable instructions. In some examples, a processor includes an FPGA or other programmable device that performs logic operations without processing computer-executable instructions. A processor can also be implemented as a combination of computing devices, for example, a combination of a DSP and a microprocessor, a plurality of microprocessors, microprocessors in conjunction with a DSP core, or any other such configuration.

Although described herein primarily with respect to digital technology, a processor may also include primarily analog components. A computing environment can include any type of computer system, including, but not limited to, a computer system based on a microprocessor, a mainframe computer, a digital signal processor, a portable computing device, a device controller, or a computational engine within an appliance, to name a few. The elements of a method, process, routine, or algorithm described in connection with the examples disclosed herein can be embodied directly in hardware, in a software module executed by a processor device, or in a combination of the two. A software module can reside in RAM memory, flash memory, ROM memory, EPROM memory, EEPROM memory, registers, hard disk, a removable disk, a CD-ROM, or any other form of a non-transitory computer-readable storage medium. An exemplary storage medium can be coupled to the processor device such that the processor device can read information from, and write information to, the storage medium. In the alternative, the storage medium can be integral to the processor device. The processor device and the storage medium can reside in an ASIC. The ASIC can reside in a user terminal. In the alternative, the processor device and the storage medium can reside as discrete components in a user terminal.

The processes described herein or illustrated in the figures of the present disclosure may begin in response to an event, such as on a predetermined or dynamically determined schedule, on demand when initiated by a user or system administrator, or in response to some other event. When such processes are initiated, a set of executable program instructions stored on one or more non-transitory computer-readable media (e.g., hard drive, flash memory, removable media, etc.) may be loaded into memory (e.g., RAM) of a server or other computing device. The executable instructions may then be executed by a hardware-based computer processor of the computing device. In some examples, such processes or portions thereof may be implemented on multiple computing devices and/or multiple processors, serially or in parallel.

Although the described flow diagrams herein can show operations as a sequential process, many of the operations can be performed in parallel or concurrently. In addition, the order of the operations may be re-arranged. A process is terminated when its operations are completed. A process may correspond to a method, a procedure, an algorithm, etc. The operations of methods may be performed in whole or in part, may be performed in conjunction with some or all of the operations in other methods, and may be performed by any number of different systems, such as the systems described herein, or any portion thereof, such as a processor included in any of the systems.

Conditional language such as, among others, "can," "could," "might" or "may," unless specifically stated otherwise, are otherwise understood within the context as used in general to convey that some examples include, while other examples do not include, some features, elements and/or steps. Thus, such conditional language is not generally intended to imply that features, elements and/or steps are in any way for examples or that examples necessarily include logic for deciding, with or without user input or prompting, whether these features, elements and/or steps are included or are to be performed in any particular example.

Disjunctive language such as the phrase "at least one of X, Y, or Z," unless specifically stated otherwise, is otherwise understood with the context as used in general to present that an item, term, etc., may be either X, Y, or Z, or any combination thereof (for example, X, Y, and/or Z). Thus, such disjunctive language is not generally intended to, and should not, imply that some examples require at least one of X, at least one of Y, or at least one of Z to each be present.

Any process descriptions, elements or blocks in the flow diagrams described herein and/or depicted in the attached figures should be understood as potentially representing modules, segments, or portions of code which include executable instructions for implementing specific logical functions or elements in the process. Alternate examples are included within the scope of the examples described herein in which elements or functions may be deleted, executed out of order from that shown, or discussed, including substantially concurrently or in reverse order, depending on the functionality involved as would be understood by those skilled in the art.

It should be emphasized that many variations and modifications may be made to the above-described examples, the elements of which are to be understood as being among other acceptable examples. All such modifications and variations are intended to be included herein within the scope of this disclosure.

Any process descriptions, elements or blocks in the flow diagrams described herein and/or depicted in the attached figures should be understood as potentially representing modules, segments, or portions of code which include executable instructions for implementing specific logical functions or elements in the process. Alternate implementations are included within the scope of the examples described herein in which elements or functions may be deleted, executed out of order from that shown, or discussed, including substantially concurrently or in reverse order, depending on the functionality involved as would be understood by those skilled in the art.

Unless otherwise explicitly stated, articles such as "a" or "an" should generally be interpreted to include one or more described items. Accordingly, phrases such as "a device configured to" are intended to include one or more recited devices. Such one or more recited devices can also be collectively configured to carry out the stated recitations. For example, "a processor configured to carry out recitations A, B, and C" can include a first processor configured to carry out recitation A working in conjunction with a second processor configured to carry out recitations B and C.

It will also be appreciated that one or more of the elements depicted in the drawings/figures can also be implemented in a more separated or integrated manner, or even removed or rendered as inoperable in certain cases, as is useful in accordance with a particular application.

## Claims

1. A method of providing electrical connectivity to a windshield of a vehicle, the method comprising:
preparing a conductive paste for forming a low resistance trace on the windshield, the low resistance trace having a linear resistance in a range 0.05-3 ohm/meter, the conductive paste comprising an inorganic ceramic frit, a silver-based compound, and a liquid medium;
applying the conductive paste to a glass substrate of the windshield using a screen printing process;
drying the applied conductive paste to remove moisture; and
firing the glass substrate with the applied conductive paste at a temperature exceeding 600°C to cure the conductive paste to form the low resistance trace on the windshield.

2. The method of claim 1, wherein the low resistance trace has a linear resistance in a range 0.1-2 ohm/meter.

3. The method of claim 2, wherein the low resistance trace has a linear resistance in a range 0.1-1 ohm/meter.

4. The method of claim 3, wherein the low resistance trace has a linear resistance of 0.1 ohm/meter.

5. The method of any one of the preceding claims, wherein a width of the low resistance trace is in a range of 3-10 millimeters (mm).

6. The method of claim 5, wherein a width of the low resistance trace is 4 mm.

7. The method of any one of the preceding claims, wherein the conductive paste further comprises a pigment.

8. The method of any one of the preceding claims, wherein the conductive paste is prepared by mixing a pre-mixed frit and the silver-based compound with the liquid medium.

9. The method of any one of the preceding claims, wherein the conductive paste is prepared by mixing a powder form of frit and silver-based enamel with the liquid medium.

10. The method of any one of the preceding claims, wherein the conductive paste is applied to an air side of the glass substrate.

11. The method of any one of the preceding claims, wherein the silver-based compound in included in a silver-based enamel; or optionally
further comprising testing the formed low resistance trace for a linear resistance value; or optionally
further comprising applying a connector on the glass substrate to connect the low resistance trace to an automotive electrical panel, a component, or a power source; or optionally
wherein the low resistance trace is insulated from another low resistance trace by a trace separation distance of at least 5 mm; or optionally wherein the low resistance trace is printed on top of or under a layer of black ceramic frit.

12. A windshield comprising:
a glass substrate; and
a low resistance trace screen-printed onto the glass substrate using a conductive paste, the low resistance trace having a linear resistance in a range 0.05-3 ohm/meter.

13. The windshield of claim 12, wherein the low resistance trace has a linear resistance in a range 0.1-2 ohm/meter; and optionally
wherein the low resistance trace has a linear resistance in a range 0.1-1 ohm/meter; and optionally
wherein the low resistance trace has a linear resistance of 0.1 ohm/meter.

14. The windshield of claim 12 and 13, wherein a width of the low resistance trace is in a range 3-10 millimeters (mm) and optionally
wherein a width of the low resistance trace is 4 mm.

15. The windshield of and one of claims 12-14, further comprising a connector integrated onto the glass substrate for connecting the low resistance trace to an automotive electrical panel, a component, or a power source; or optionally
wherein the conductive paste comprises a silver-based compound; or optionally
wherein the low resistance trace is insulated from another low resistance trace by a trace separation distance of at least 5 mm; or optionally wherein the low resistance trace is printed on top of or under a layer of black ceramic frit.
